# EUROPEAN PATENT SPECIFICATION

(11) **EP 4 453 773 B1**
(45) Date of publication and mention of the grant of the patent: **04.02.2026**
(21) Application number: 22911135.6
(22) Date of filing: 16.12.2022
(51) Int. Cl.: G06T 11/80, G06T 11/20, G06F 30/10, G06F 30/12, G06T 11/60, G06F 30/17

(54) **DRAWING ASSISTANCE DEVICE AND DRAWING ASSISTANCE METHOD**
ZEICHENASSISTENZVORRICHTUNG UND ZEICHENASSISTENZVERFAHREN
DISPOSITIF D'AIDE AU DESSIN ET PROCÉDÉ D'AIDE AU DESSIN

(30) Priority: 22.12.2021 IN 202141060025
(43) Date of publication of application: 30.10.2024
(73) Proprietor: Amada Co., Ltd., Isehara-shi, Kanagawa 259-1196 (JP)
(72) Inventor: NAKAMOTO, Shuji, Isehara-shi, Kanagawa 259-1196 (JP); VASUDEVAN, Praveenkumar, Isehara-shi, Kanagawa 259-1196 (JP); THOLATH, Jackson, Chennai 600113 (IN); NAGURU, Gowri Prasadh, Chennai 600113 (IN)
(74) Representative: Grünecker Patent- und Rechtsanwälte PartG mbB
(86) International application number: PCT/JP2022/046477
(87) International publication number: WO 2023/120432

(56) References cited:
- JP-A- 2001 243 490
- JP-A- H06 309 394
- JP-A- H08 194 736
- JP-A- H09 128 418
- JP-A- H09 128 418
- US-A- 5 729 750
- SERGEY V. ABLAMEYKO ET AL: "Recognition of engineering drawing entities: review of approaches", INTERNATIONAL JOURNAL OF IMAGE AND GRAPHICS, vol. 7, no. 4, 1 October 2007 (2007-10-01), pages 709 - 733, XP055228784, ISSN: 0219-4678, DOI: 10.1142/S0219467807002878

## Description

### Technical Field

The present invention relates to a drawing assistance device and a drawing assistance method.

### Background Art

Patent Literature 1 (PTL 1) discloses a service regarding drawing by use of computer aided design (CAD) that converts raster data into vector data. The conventional CAD data converting method disclosed in Patent Literature 1 stores various kinds of CAD data conversion soft in a server, and converts the raster data into the vector data by use of the stored CAD data conversion soft.
JP H09-128418 A relates to recognizing dimensional information in construction drawings. Recognition rules tolerate broken or faint lines, overlapping annotations and skewed scans by cross-checking character shapes, aspect ratios and spacing.
SERGEY V. ABLAMEYKO ET AL: "Recognition of engineering drawing entities: review of approaches", INTERNATIONAL JOURNAL OF IMAGE AND GRAPHICS, vol. 7, no. 4, 1 October 2007 (2007-10-01), pages 709-733, ISSN: 0219-4678, DOI: 10.1142/S0219467807002878 Relates to automatically recognizing entities in 2-D engineering drawings. Specialized algorithms for extracting dimension information are surveyed and it is mentioned that text, leaders and arrowheads are tightly intertwined.
US 5 729 750 A relates to Automatic dimensioning in computer-aided design. Every geometric element is classified (lines, chamfers, circles, bores, etc.) into dedicated tables, then a two-stage routine is run that first provisionally places extension & dimension lines along the X- and Y-axes and afterwards rearranges them. During the rearrangement step, larger numerical dimensions are pushed further away from the part outline than smaller ones, and overlaps/unnecessary duplicates are removed.

### Citation List

### Patent Literature

PTL 1: Japanese Unexamined Patent Application Publication No. 2003-186915

### Summary of Invention

### Technical Problem

When a design diagram is converted from the raster data to the vector data, the conventional method requires an operator to read to manually input dimension values and dimension lines drawn on the raster data to a computer system.

The manual inputting operation made by the operator has a problem taking a long operating time and increasing a probability of causing operational errors accordingly. The invention is defined by the features of the independent claims. Any reference to inventions or embodiments not falling within the scope of the independent claims are to be interpreted as examples useful for understanding the invention.

### Solution to Problem

A drawing assistance device and a drawing assistance method according to one aspect of the present invention include a controller configured to assist an operator with a drawing operation of converting image data of a design diagram into digital data, the controller being configured to acquire the image data of the design diagram to detect dimensional information drawn on the image data, detect an arrow drawn on the image data, detect a line drawn on the image data, combine the arrow and the line based on a position of the arrow and a position of the line to generate a dimension line, detect a dimension value corresponding to a position of the dimension line from the dimensional information so as to assign the detected dimension value to the dimension line, generate guidelines perpendicular to the dimension line and passing through positions of ends of the dimension line, superpose the guidelines on the image data to display the guidelines on an editing screen, and output the digital data of the design diagram drawn by the operator on the editing screen on which the guidelines are displayed.

The drawing assistance device and the drawing assistance method having the above configuration are configured to generate the dimension line from the image data, assign the dimension value corresponding to the position of the dimension line to the dimension line, and generate the guidelines indicating the positions of the ends of the dimension line. This configuration enables the operator to draw the design diagram by use of the guidelines, so as to decrease the operating time, and reduce the probability of causing the operational errors accordingly.

### Advantageous Effects of Invention

The drawing assistance device and the drawing assistance method according to the aspect of the present invention can reduce the operating time taken by the operator, so as to reduce the probability of causing the operational errors.

### Brief Description of Drawings

[Fig.1]Fig. 1 is a block diagram illustrating a configuration of a drawing assistance device according to an embodiment.
[Fig.2]Fig. 2 is a diagram for explaining a method of detecting dimensional information by the drawing assistance device according to an embodiment.
[Fig.3]Fig. 3 is a diagram for explaining a method of detecting arrows by the drawing assistance device according to an embodiment.
[Fig.4]Fig. 4 is a diagram for explaining a method of detecting symbols by the drawing assistance device according to an embodiment.
[Fig.5]Fig. 5 is a diagram illustrating dimension lines and guidelines generated by the drawing assistance device according to an embodiment.
[Fig.6]Fig. 6 is a diagram showing an example of an editing screen displayed by the drawing assistance device according to an embodiment.
[Fig.7]Fig. 7 is a flowchart showing a process procedure of drawing assistance processing executed by the drawing assistance device according to an embodiment.
[Fig.8]Fig. 8 is a diagram showing an example of the editing screen displayed by the drawing assistance device according to an embodiment.
[Fig.9]Fig. 9 is a flowchart showing a process procedure of line correction processing executed by the drawing assistance device according to an embodiment.
[Fig.10A]Fig. 10A is a diagram for explaining a method of correcting lines by the drawing assistance device according to an embodiment.
[Fig.10B]Fig. 10B is a diagram for explaining the method of correcting lines by the drawing assistance device according to an embodiment.
[Fig.10C]Fig. 10C is a diagram for explaining the method of correcting lines by the drawing assistance device according to an embodiment.
[Fig.10D]Fig. 10D is a diagram for explaining the method of correcting lines by the drawing assistance device according to an embodiment.
[Fig.11A]Fig. 11A is a diagram showing an example of dimension lines generated by the drawing assistance device according to an embodiment.
[Fig.11B]Fig. 11B is a diagram showing an example of dimension lines generated by the drawing assistance device according to an embodiment.
[Fig.12] Fig. 12 is a diagram showing an example of the editing screen displayed by the drawing assistance device according to an embodiment.
[Fig.13] Fig. 13 is a diagram showing an example of the editing screen displayed by the drawing assistance device according to an embodiment.
[Fig.14] Fig. 14 is a flowchart showing a process procedure of symbol generation processing executed by the drawing assistance device according to an embodiment.

### Description of Embodiments

An embodiment to which the present invention is applied is described below with reference to the drawings. The same elements illustrated in the drawings are denoted by the same reference numerals, and overlapping explanations are not made below.

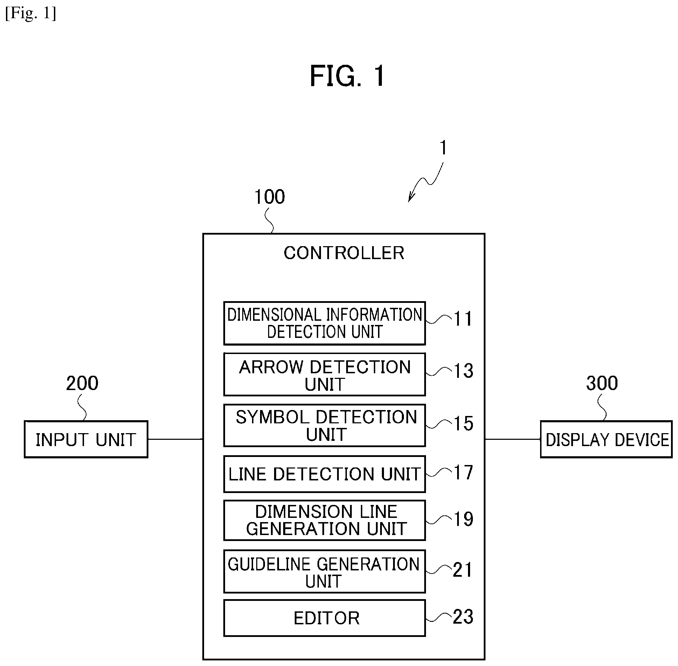

Fig. 1 is a block diagram illustrating a configuration of a drawing assistance device according to the present embodiment. The drawing assistance device 1 illustrated in Fig. 1 includes a controller 100, an input unit 200, and a display device 300. The drawing assistance device 1 is a device for assisting an operator with a drawing operation, and in particular, assists the operator with a drawing operation of converting image data of a design diagram such as raster data into digital data such as vector data.

The controller 100 executes drawing assistance processing of assisting the operator with the drawing operation of converting the image data of the design diagram such as a computer aided design (CAD) diagram into the digital data. The controller 100 includes a dimensional information detection unit 11, an arrow detection unit 13, a symbol detection unit 15, a line detection unit 17, a dimension line generation unit 19, a guideline generation unit 21, and an editor 23, as illustrated in Fig. 1.

The input unit 200 acquires the image data of the design diagram such as a CAD diagram to store the image data to a database (not illustrated). For example, the input unit 200 reads the design diagram with a scanner, and stores the acquired image data such as raster data to the database (not illustrated).

The display unit 300 is a device for displaying the information output from the controller 100, and displays an editing screen and the like displayed by the editor 23.

The respective elements of the controller 100 are described below. The dimensional information detection unit 11 acquires the image data of the design diagram to detect dimensional information drawn on the image data. In particular, the dimensional information detection unit 11 acquires the raster data of the design diagram from the database, and detects the dimensional information drawn on the raster data by use of an Optical Character Recognition (OCR) machine learning algorithm.

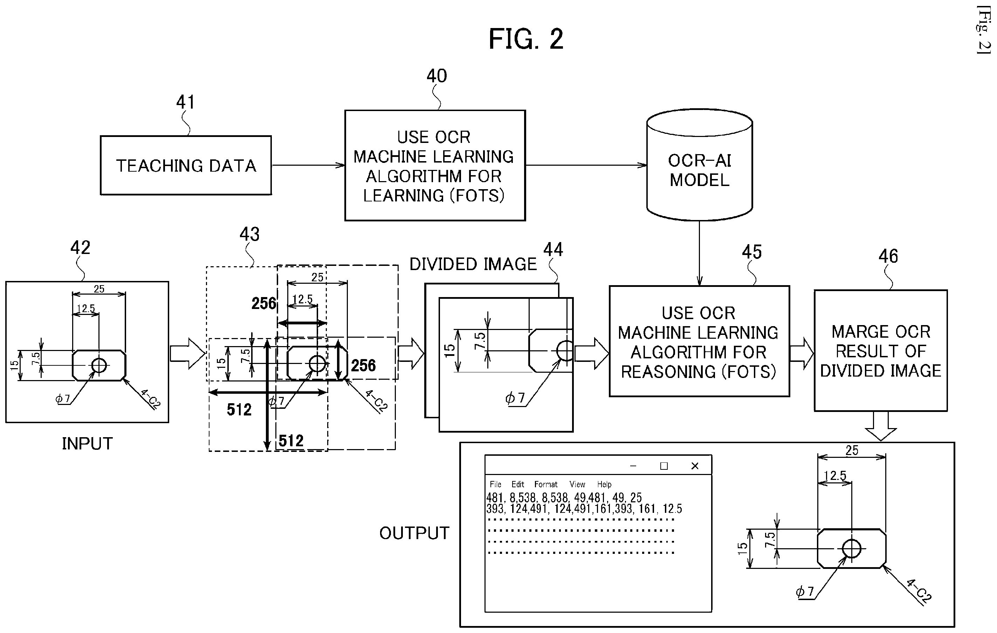

A method of detecting the dimensional information is described in detail below with reference to Fig. 2. The OCR machine learning algorithm 40 has learned the design diagram by use of teaching data 41 preliminarily prepared, as illustrated in Fig. 2. For example, the OCR machine learning algorithm to be used is a deep learning model called Fast Oriented Text Spotting (FOTS), and a set of data in which the CAD diagram is divided into 512 × 512 image patches is prepared as the teaching data 41. The FOTS is then caused to learn the design diagram by use of the teaching data 41 so as to detect the dimensional information such as dimension values drawn on the CAD diagram.

The dimensional information is detected by use of the OCR machine learning algorithm having learned. When the dimensional information is actually detected from the raster data, the raster data 42 of the input CAD diagram is divided into the 512 × 512 image patches (43), and the divided raster data 44 is input to the OCR machine learning algorithm (FOTS) 45 having learned. The divided image patches overlap with each other by 256 pixels.

The OCR machine learning algorithm recognizes the dimension values per divided image to determine the recognized dimension values as a detection result (45). The OCR machine learning algorithm merges and outputs the detection result of each divided image (46). The output is a Comma Separated Value (CSV) file in which the numerical values and the positions of the dimensions are stored. For example, as illustrated in Fig. 2, the CSV file stores the dimensional numerical values such as "25" and "12.5", and the positions of bounding boxes surrounding the numerical values.

The arrow detection unit 13 detects arrows drawn on the image data. In particular, the arrow detection unit 13 acquires the raster data of the design diagram from the database, and detects the positions of the tips and the directions of the arrows drawn on the raster data by use of an object recognition algorithm.

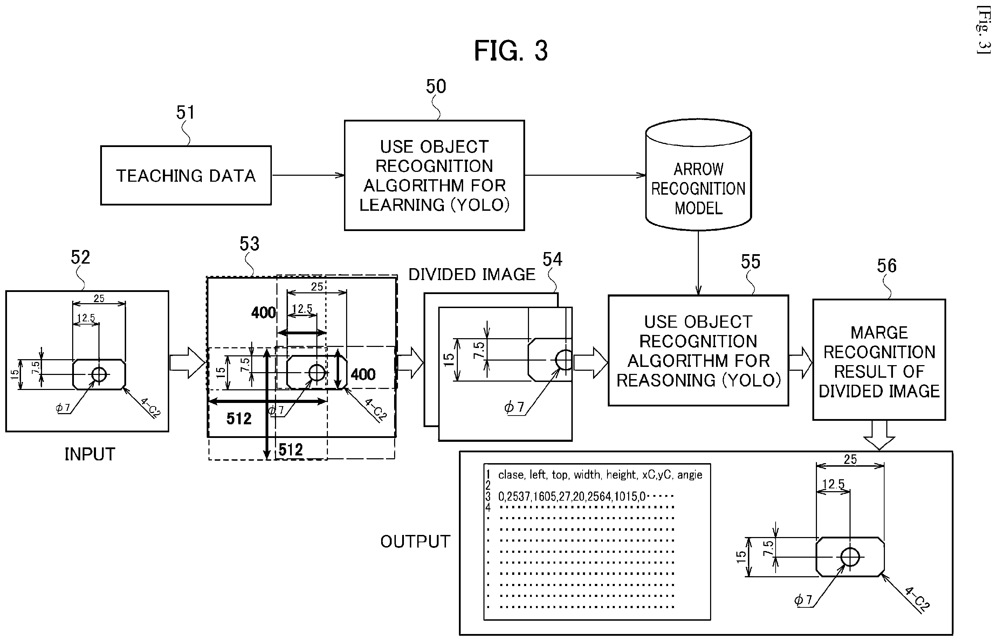

A method of detecting the arrows is described in detail below with reference to Fig. 3. The object recognition algorithm 50 has learned the design diagram by use of teaching data 51 preliminarily prepared, as illustrated in Fig. 3. For example, the object recognition algorithm to be used is an object recognition deep learning model called YOLO, and a set of data in which the CAD diagram is divided into 512 × 512 image patches is prepared as the teaching data 51. The YOLO is then caused to learn the design diagram by use of the teaching data 51 so as to detect the arrows drawn on the CAD diagram.

The arrows are detected by use of the object recognition algorithm having learned. When the arrows are actually detected from the raster data, the raster data 52 of the input CAD diagram is divided into the 512 × 512 image patches (53), and the divided raster data 54 is input to the object recognition algorithm (YOLO) 55 having learned. The divided image patches overlap with each other by 400 pixels.

The object recognition algorithm recognizes the arrows per divided image, and calculates the positions of the tips and the directions of the recognized arrows to determine them as a detection result (55). The object recognition algorithm merges and outputs the detection result of each divided image (56). The output is a CSV file in which the positions of the tips and the directions of the recognized arrows are stored. For example, as illustrated in Fig. 3, the CSV file stores a label "0" indicating the arrows, the positions of the bounding boxes surrounding the arrows, and the directions (the angles) of the arrows.

The symbol detection unit 15 detects symbols drawn on the image data. In particular, the symbol detection unit 15 acquires the raster data of the design diagram from the database, and detects the positions of the symbols drawn on the raster data by use of the object recognition algorithm. Example of the symbols to be detected include a hole and a screw.

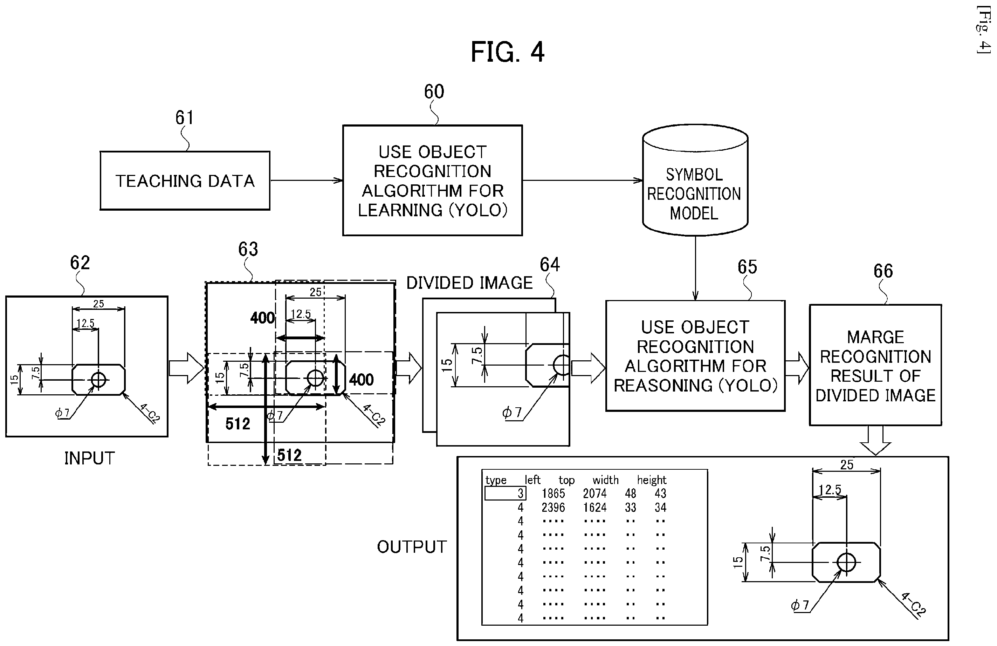

A method of detection the symbols is described in detail below with reference to Fig. 4. The object recognition algorithm 60 has learned the design diagram by use of teaching data 61 preliminarily prepared, as illustrated in Fig. 4. For example, the object recognition algorithm to be used is an object recognition deep learning model called YOLO, and a set of data in which the CAD diagram is divided into 512 × 512 image patches is prepared as the teaching data 61. The YOLO is then caused to learn the design diagram by use of the teaching data 61 so as to detect the symbols drawn on the CAD diagram.

The symbols are detected by use of the object recognition algorithm having learned. When the symbols are actually detected from the raster data, the raster data 62 of the input CAD diagram is divided into the 512 × 512 image patches (63), and the divided raster data 64 is input to the object recognition algorithm (YOLO) 65 having learned. The divided image patches overlap with each other by 400 pixels.

The object recognition algorithm recognizes the symbols per divided image to determine the recognized symbols as a detection result (65). The object recognition algorithm merges and outputs the detection result of each divided image (66). The output is a CSV file in which the types and the positions of the recognized symbols are stored. For example, as illustrated in Fig. 4, the CSV file stores a label "3" or "4" indicating the type of the symbol, and the position of the bounding box surrounding the symbol. The label "3" indicates a screw, and the label "4" indicates a hole.

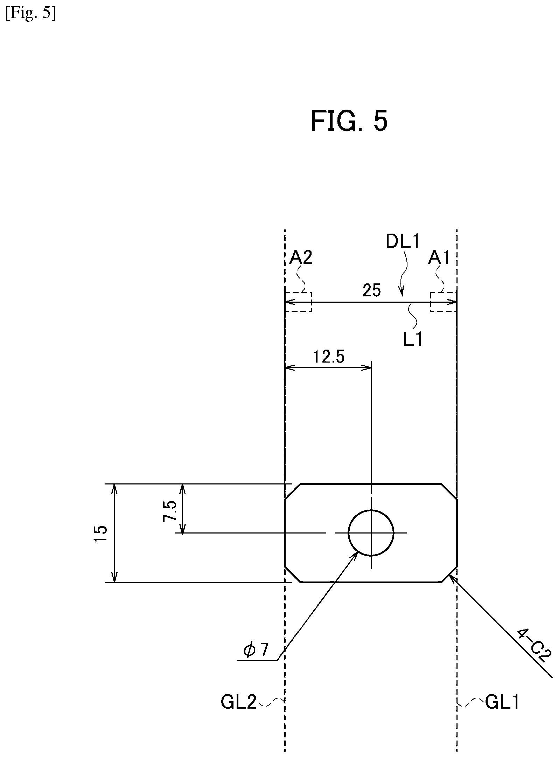

The line detection unit 17 detects lines drawn on the image data. In particular the line detection unit 17 acquires the raster data of the design diagram from the database, and executes image processing such as Hough transform so as to detect the positions of the lines or circular arcs drawn on the raster data. For example, in the design diagram illustrated in Fig. 5, all of the positions of the lines drawn on the raster data are detected.

The dimension line generation unit 19 combines the arrows and the lines based on the positions of the arrows detected by the arrow detection unit 13 and the positions of the lines detected by the line detection unit 17 and generates the dimension lines. For example, in the case in which arrows A1 and A2 and a line L1 are detected, as illustrated in Fig. 5, the positions of the arrows A1 and A2 and the position of the line L1 overlap with each other, these are thus combined together to generate the dimension line DL1.

The dimension line generation unit 19 also detects the dimension value corresponding to the position of the generated dimension line from the dimensional information, and assigns the detected dimension value to the dimension line. For example, as illustrated in Fig. 5, the dimension line generation unit 19 detects "25" as a dimension value corresponding to the position of the generated dimension line DL1, and assigns the dimension value to the dimension line DL1. As a specific example of the detecting method, the present embodiment may detect the dimension value indicated above the middle point of the dimension line DL1. When the dimension line is a vertical line, the present embodiment may detect the dimension value indicated on the left of the middle point of the dimension line. Alternatively, the present embodiment may detect the dimension value indicated closest to the dimension line.

The dimension line generation unit 19, after assigning the dimension value to the dimension line, sets a length of the dimension line to the dimension value assigned to the dimension line. For example, as illustrated in Fig. 5, when the dimension value "25" is assigned to the dimension line DL1, the length of the dimensional line DL1 is set to 25 mm. The dimension line generation unit 19 generates all of the dimension lines drawn on the raster data in the same manner as described above.

The guideline generation unit 21 generates guidelines indicating the positions of the ends of the dimension line generated by the dimension line generation unit 19. In particular, the guideline generation unit 21 generates guidelines perpendicular to the dimension line and passing through the tips of the arrows of the generated dimension line. For example, as illustrated in Fig. 5, the guideline generation unit 21 generates guidelines GL1 and GL2 perpendicular to the dimension line DL1 and passing through the tips of the arrows A1 and A2 of the generated dimension line DL1. The guidelines GL1 and GL2 indicated by the dotted lines in Fig. 5 partly overlap with and are thus hidden by the lines on the raster image, but continuously extend in the upper-lower direction. The guideline generation unit 21 generates the guidelines for all of the dimension lines generated by the dimension line generation unit 19 in the same manner as described above.

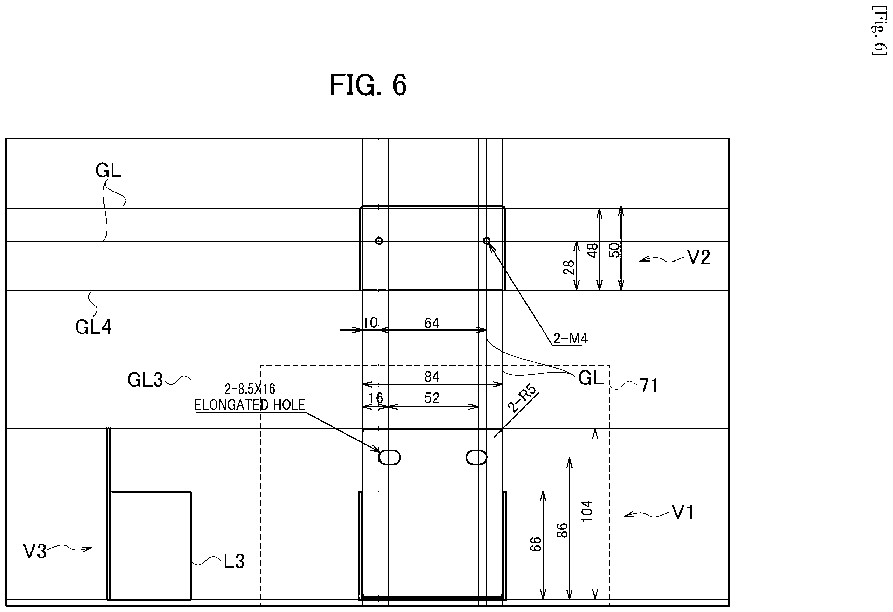

The editor 23, which is an editing function enabling the operator to draw the design diagram, superposes the guidelines generated by the guideline generation unit 21 on the raster data of the input CAD diagram, and displays the guidelines on the editing screen. For example, as illustrated in Fig. 6, a front view V1, a top view V2, and a side view V3 of the input raster data are displayed on the editing screen displayed by the editor 23. A plurality of guidelines GL are superposed on the raster data and are displayed on the editing screen in the vertical direction and in the horizontal direction.

The operator draws the diagram by use of the guidelines GL in accordance with the raster data on the editing screen on which the guidelines GL are displayed. When the operator finishes to draw all of the figures drawn on the raster data on the editing screen, the CAD diagram input as the raster data can be converted into the digital data such as vector data. The editor 23 outputs the converted vector data.

The controller 100 is composed of a general-purpose electronic circuit including a microcomputer, a microprocessor, and a CUP, and a peripheral device such as a memory, and has a function of assisting the operator with the drawing operation of converting the image data of the design diagram into the digital data. The respective functions of the controller 100 can be implemented by one or plural processing circuits. The respective processing circuits include a programed processing device, such as a processing circuit including an electrical circuit, and include an application-specific integrated circuit (ASIC) arranged to execute the functions described in the present embodiment and a device such as a conventional circuit component.

### <Drawing Assistance Method of Drawing Design diagram>

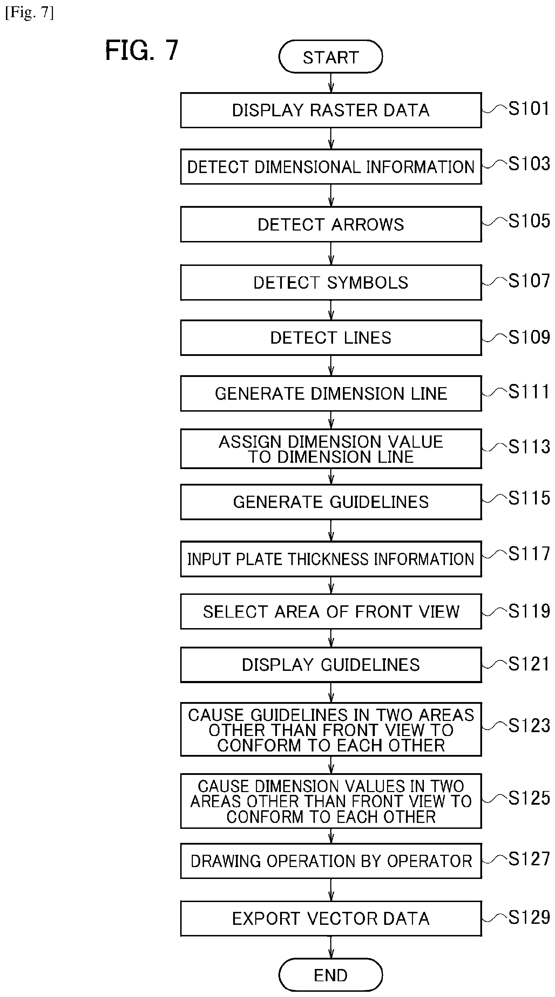

A drawing assistance method of drawing the design diagram by the drawing assistance device 1 according to the present embodiment is described below. Fig. 7 is a flowchart showing a process procedure of drawing assistance processing executed by the drawing assistance device 1 according to the present embodiment.

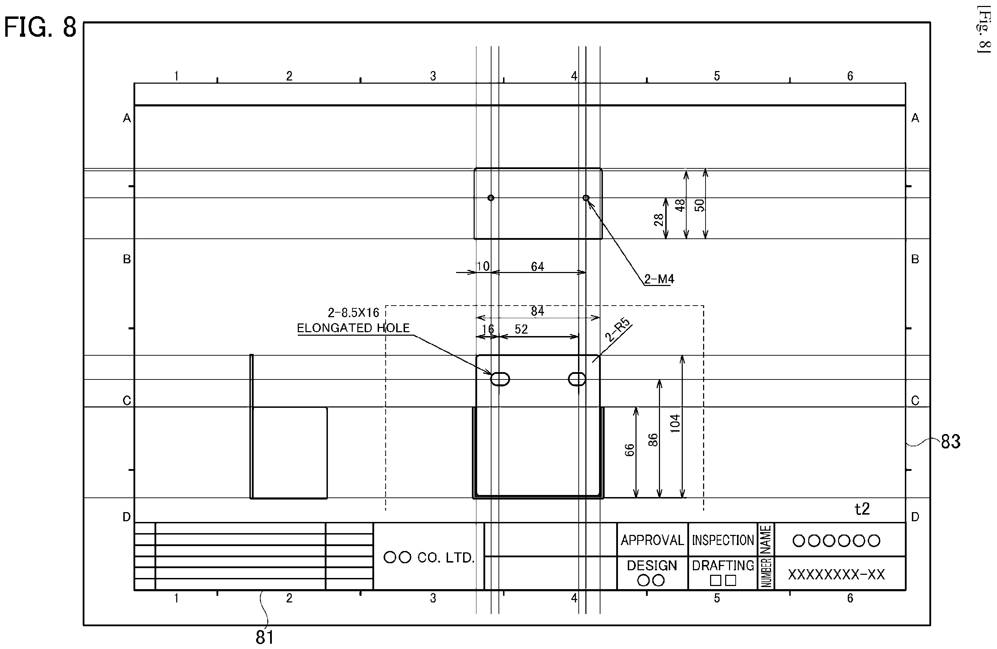

As illustrated in Fig. 7, in step S101, the editor 23 opens the editing screen, and displays the raster data of the CAD diagram input through the input unit 200 by the operator. The editor 23 at this point erases title information drawn on the raster data. For example, as illustrated in Fig. 8, the title information 81 including a name of a company, a name of a person in charge, a name of an article and the like is preliminarily erased when displayed on the lower side of the raster image. In particular, the editor 23 detects a region having a rectangular shape located in contact with an outer circumference 83 of the raster image, and determines that the region is presumed to include the title information 81 and erases the region. This step can eliminate unnecessary information drawn on the raster data, so as to reduce the processing load to enhance the processing speed accordingly.

In step S103, the dimensional information detection unit 11 acquires the raster data of the CAD diagram, and detects the dimensional information drawn on the raster data. In particular, the dimensional information detection unit 11 inputs the raster data to the OCR machine learning algorithm having learned, and detects the values of the dimensions and the positions of the dimensions drawn on the raster image.

In step S105, the arrow detection unit 13 acquires the raster data of the CAD diagram, and detects the arrows drawn on the raster data. In particular, the arrow detection unit 13 inputs the raster data to the object recognition algorithm having learned, and detects the positions of the tips and the directions of the arrows drawn on the raster image.

In step S107, the symbol detection unit 15 acquires the raster data of the CAD diagram, and detects the symbols such as a hole and a screw drawn on the raster data. In particular, the symbol detection unit 15 inputs the raster data to the object recognition algorithm having learned, and detects the types and the positions of the symbols drawn on the raster image.

In step S109, the line detection unit 17 acquires the raster data of the CAD diagram, and detects the lines drawn on the raster data. In particular, the line detection unit 17 performs the image processing such as Hough transform on the raster data, and detects the lines or circular arcs drawn on the raster image.

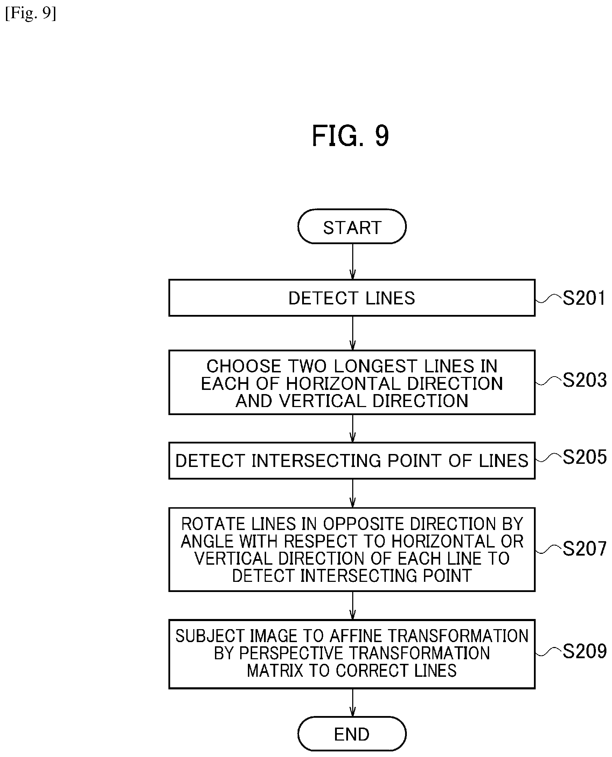

When the respective detected lines are not a horizontal or vertical line, the line detection unit 17 rotates the lines and corrects the lines so as to be oriented horizontally or vertically. The processing of correcting the lines by the line detection unit 17 is described in detail below. Fig. 9 is a flowchart showing a process procedure of the line correction processing.

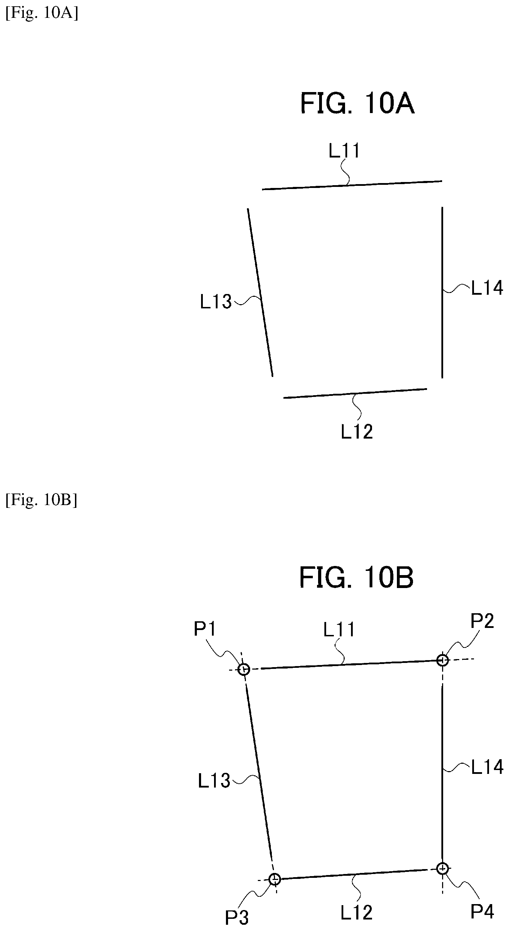

As illustrated in Fig. 9, the line detection unit 17 executes the Hough transform to detect the lines drawn on the raster image in step S201, and chooses the two longest lines from the detected lines in each of the horizontal direction and the vertical direction in step S203. For example, as illustrated Fig. 10A, when the detected lines are leaned, the line detection unit 17 chooses the two lines L11 and L12 longest in the horizontal direction and the two lines L13 and L14 longest in the vertical direction.

In step S205, the line detection unit 17 detects the intersecting points of the lines chosen in step S203. For example, as illustrated in Fig. 10B, the line detection unit 17 extends the lines L11 to L14 chosen in step S203, and detects the intersecting points P1 to P4 of the respective lines L11 to L14.

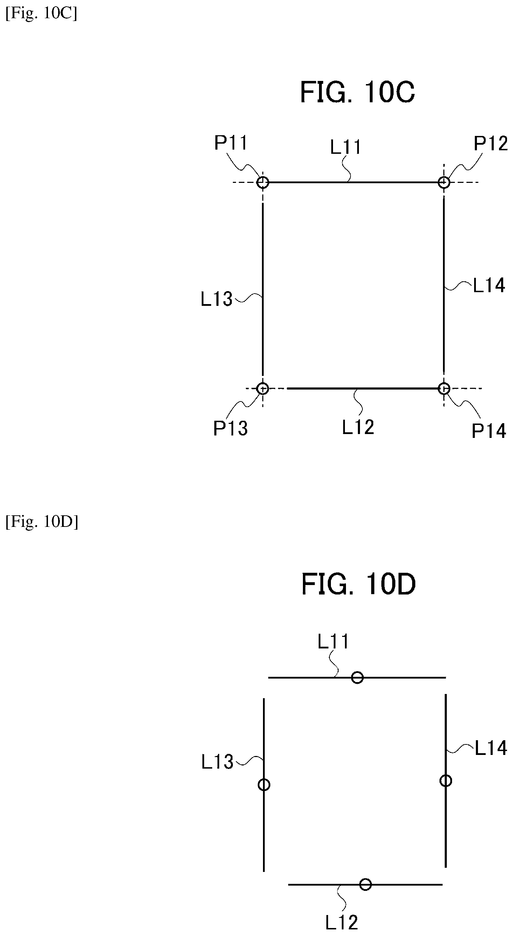

In step S207, the line detection unit 17 detects the angle of the respective lines with respect to the horizontal direction or the vertical direction, and rotates the respective lines by the detected angle in the opposite direction so as to detect the intersecting points of the lines. For example, as illustrated in Fig. 10C, the line detection unit 17 detects the angle of the line L11 leaned with respect to the horizontal direction, and rotates the line L11 by the detected angle in the direction opposite to the leaned direction. The line detection unit 17 also rotates the other lines L12 to L14 in the same manner as described above to calculate the intersecting points P11 to P14 after the rotation.

In step S209, the line detection unit 17 calculates a perspective transformation matrix for converting the intersecting points P1 to P4 detected in step S205 into the intersecting points P11 to P14 calculated in step S207. The line detection unit 17 performs affine transformation on the image by use of the calculated perspective transformation matrix so as to correct the leaned lines. In particular, as illustrated in Fig. 10D, the lines are rotated about the middle point in the direction opposite to the leaned direction so as to correct the lines L11 to L14 to be oriented horizontally or vertically. As a result, even if the lines of the input raster image are leaned, the lines can be corrected horizontally or vertically.

Returning to the flowchart shown in Fig. 7, in step S111, the dimension line generation unit 19 combines the arrows and the lines based on the positions of the arrows detected in step S105 and the positions of the lines detected in step S109 and generates the dimension lines. For example, when the arrows A1 and A2 and the line L1 are detected, these are combined together to generate the dimension line DL1, as illustrated in Fig. 5.

In step S113, the dimension line generation unit 19 detects the dimension value corresponding to the position of the dimension line generated in step S111 from the dimensional information, and assigns the detected dimension value to the dimension line. For example, as illustrated in Fig. 5, the dimension line generation unit 19 detects "25" as the dimension value corresponding to the position of the generated dimension line DL1 from the dimensional information detected in step S103, and assigns the value to the dimension line DL1.

The dimension line generation unit 19 sets the length of the dimension line to the dimension value assigned to the dimension line after assigning the dimension value to the dimension line. For example, in the case illustrated in Fig. 5, the length of the dimension line DL1 is set to 25 mm that is the assigned dimension value. Setting the length of the dimension line DL1 to the assigned dimension value enables the drawing of the dimension line having an accurate length.

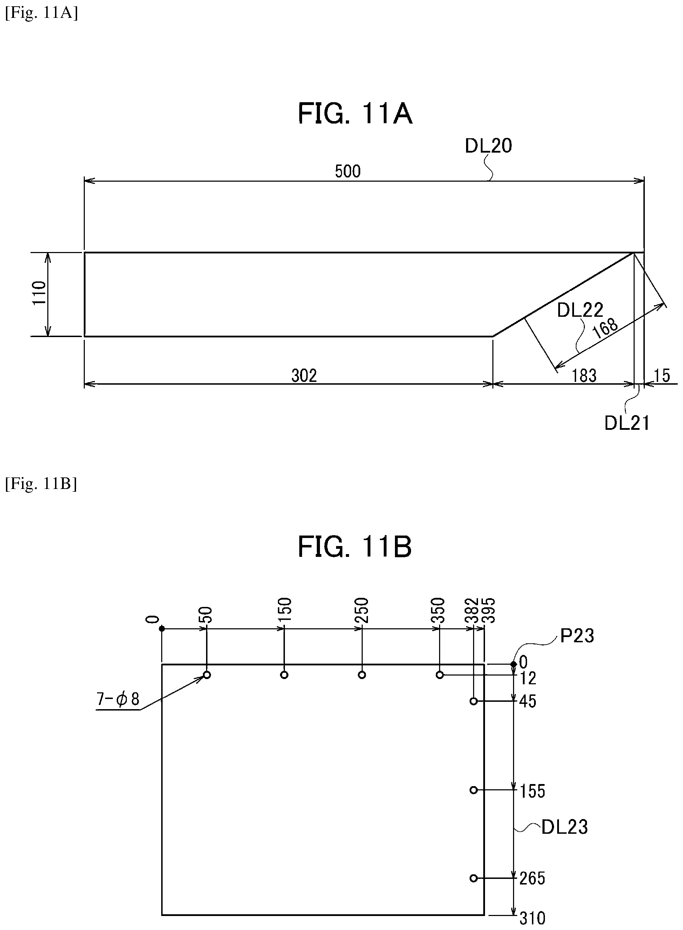

The type of the dimension lines generated by the dimension line generation unit 19 includes a dimension line DL21 interposed between the two arrows, and a dimension line DL22 drawn in parallel to a diagonal structural line, as illustrated in Fig. 11A, in addition to the typical straight dimension line DL20. The dimension line generation unit 19 may generate a dimension line DL23 including a plurality of dimension lines each indicating a distance from a black-dot point P23, as illustrated in Fig. 11B. The dimension line DL23 includes the dimension lines having the lengths from the point P23 ranging from 12 mm to 310 mm. The arrow detection unit 13 thus can detect the black dot, in addition to the arrows. In this case, the arrow detection unit 13 may be caused to learn in advance so as to detect the black dot as an end of the dimension line. The arrow detection unit 13 may be caused to learn so as to detect a white circle that could be indicated as the end of the dimension line instead of the black dot.

In step S115, the guideline generation unit 21 generates the guidelines indicating the positions of the ends of the dimension line generated in step S111. In particular, the guideline generation unit 21 generates the guidelines perpendicular to the dimension line and passing through the tips of the arrows of the generated dimension line. For example, as illustrated in Fig. 5, the guide line generation unit 21 generates the guidelines GL1 and GL2 perpendicular to the dimension line DL1 and passing through the tips of the arrows A1 and A2 of the generated dimension line DL1.

In step S117, the editor 23 instructs the operator to input the plate thickness information that is the numerical value of the plate thickness necessary for drawing the CAD diagram.

In step S119, the editor 23 causes the operator to select the area of the front view from the raster image displayed on the editing screen. For example, as illustrated in Fig. 6, the operator selects the area 71 of the front view V1 from the editing screen showing the front view V1, the top view V2, and the side view V3.

In step S121, the editor 23 superposes the guidelines generated in step S115 on the raster image displayed on the editing screen so as to display the guidelines on the editing screen. For example, as illustrated in Fig. 6, the editor 23 superposes the plural guidelines GL on the raster image on the editing screen so as to display the respective guidelines GL on the editing screen in the vertical direction and in the lateral direction.

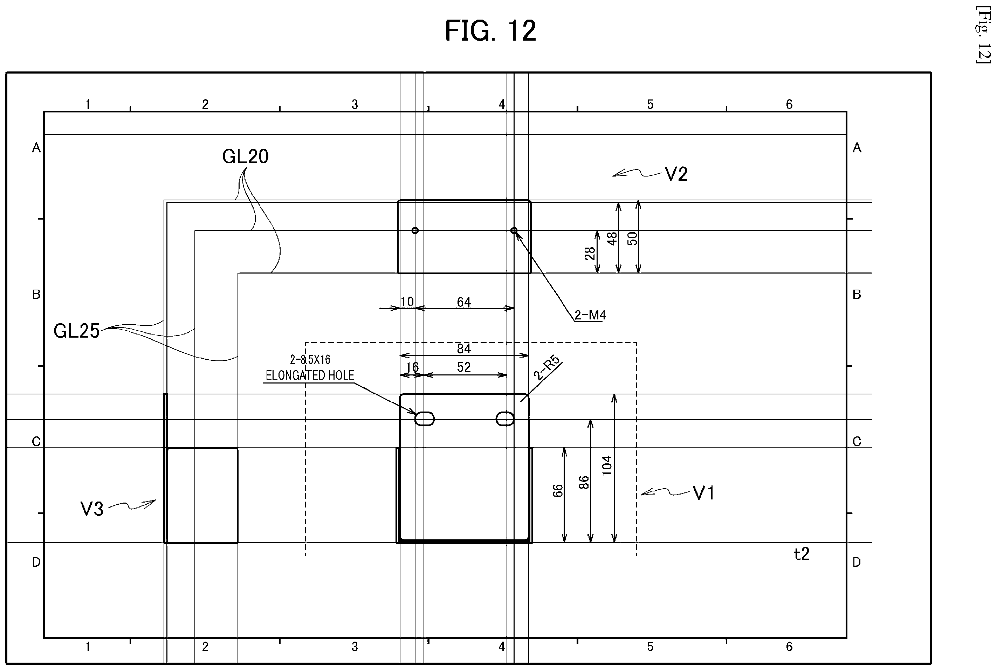

In step S123, the editor 23 causes the operator to designate the correspondence between the guidelines drawn on the two areas other than the front view. For example, when the operator moves a cursor of a pointing device onto the line L3 in the side view V3 illustrated in Fig. 6, the editor 23 generates the guideline GL3 corresponding to the line L3. When the operator selects the guideline GL3 and the guideline GL4 in the top view V2, the correspondence between the guideline GL3 in the side view V3 and the guideline GL4 in the top view V2 is designated. This designation connects a plurality of guidelines GL20 extending in the lateral direction in the top view V2 with a plurality of guidelines GL25 extending in the perpendicular direction in the side view V3, as illustrated in Fig. 12.

In step S125, the editor 23 causes the dimension values to conform to each other drawn on the two areas in which the correspondence is designated in step S123. For example, when the correspondence between the top view V2 and the side view V3 is designated, as illustrated in Fig. 12, the dimension values in the top view V2 are transferred to the side view V3 so as to cause the dimension values in the side view V3 to conform to the dimension values in the top view V2. This correspondence enables the accurate drawing of the side view V3 by use of the dimension values in the top view V2 even if the dimension values are not indicated in the side view V3.

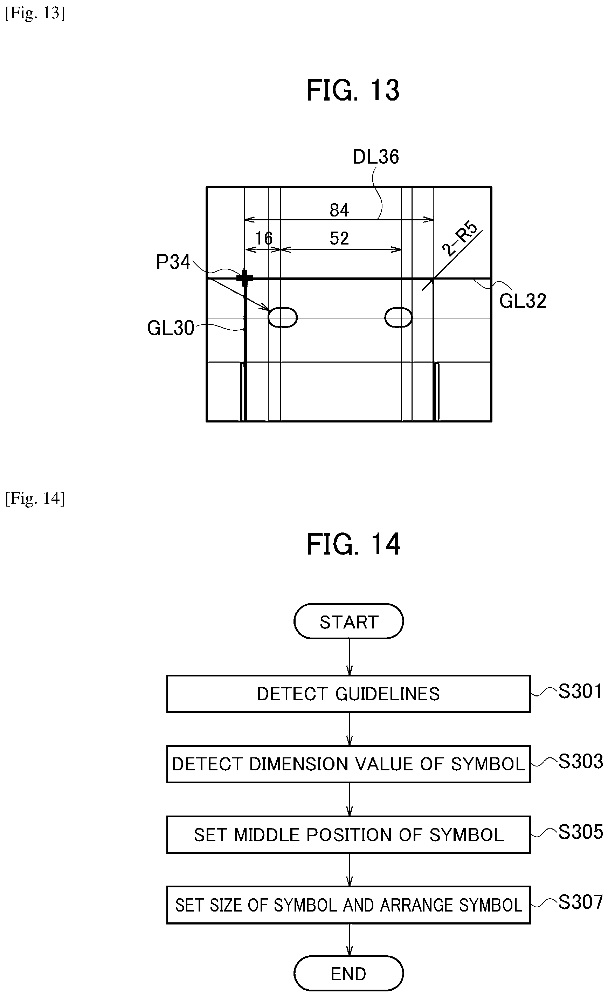

In step S127, the operator performs the drawing operation on the editing screen. In particular, the operator performs the drawing operation by use of the guidelines while seeing the raster image displayed on the editing screen. For example, when the operator moves the cursor of the pointing device onto the guide line on the editing screen, the guideline GL30 on which the cursor is positioned is highlighted, as illustrated in Fig. 13. The other guideline GL32 intersecting with the guideline GL30 is then highlighted, and the intersecting point P34 between the guide lines GL30 and GL32 is also highlighted. When the operator selects the intersecting point P34, the guidelines GL30 and the GL32 intersecting at the intersecting point P34 are selected. This enables the operator to trace and draw the selected guidelines GL30 and GL32 with a solid line or a broken line, so as to easily draw the shapes drawn on the raster image.

The operator can change the dimension value assigned to the dimension line so as to change the length of the dimension line. For example, when the operator changes the dimension value "84" shown in Fig. 13 to "60", the length of the dimension line DL36 can be changed to 60 mm. The operator thus can easily draw up the parts having similar shapes but different sizes. The operator also draws a cut part or an R part at each corner drawn on the raster image, and designates a plate-thickness surface as necessary.

The symbol such as a screw or a hole may be drawn by the operator, or the symbol detected by the symbol detection unit 15 may be used. For example, when the operator draws the symbol, the operator determines the middle of the symbol by using the guideline, so as to arrange the shape corresponding to the symbol such as a screw or a hole in the middle of the symbol.

When the symbol detected by the symbol detection unit 15 is used, the symbol detection unit 15 generates the symbol on the editing screen. Fig. 14 is a flowchart showing a process procedure of the symbol generation processing.

As shown in Fig. 14, the symbol detection unit 15 detects the guidelines passing through the position of the symbol in step S301, and detects the dimension value corresponding to the position of the symbol from the dimensional information in step S303.

In step S305, the symbol detection unit 15 sets the intersecting point of the guidelines detected in step S301 to a middle position of the symbol.

In step S307, the symbol detection unit 15 assigns the dimension value detected in step S303 to the symbol, and sets a size of the symbol to the assigned dimension value. The symbol detection unit 15 then arranges the set symbol in the middle position set in step S305. As a result, the symbol having an accurate dimension value can be easily drawn, and the symbol generated by the symbol detection unit 15 can be used to display the symbol on the editing screen.

When the operator performing the drawing operation on the editing screen finishes drawing all of the figures on the raster image, the operator ends the drawing operation after inspecting the dimensions by use of an automatic dimension recognition function.

In step S129, the editor 23 exports the vector data drawn on the editing screen, and completes the drawing assistance processing of the design diagram according to the present embodiment.

### <Effects of Embodiment>

As described above, the drawing assistance device 1 according to the present embodiment combines the arrows and the lines drawn on the image data to generate the dimension lines, detects the dimension values corresponding to the positions of the dimension lines from the dimensional information, and assigns the detected dimension values to the dimension lines. The drawing assistance device 1 generates the guidelines indicating the positions of the ends of the dimension lines, superposes the guidelines on the image data to display the guidelines on the editing screen, and outputs the digital data of the design diagram drawn by the operator on the editing screen on which the guidelines are displayed. This enables the operator to draw the design diagram by use of the guidelines on the editing screen, thus, the operating time can be decreased, and a probability of causing operational errors can be reduced.

The drawing assistance device 1 according to the present embodiment sets the length of the dimension line to the dimension value assigned to the dimension line. Setting the length of the dimension line to the assigned dimension value can draw the dimension line having an accurate length.

In the drawing assistance device 1 according to the present embodiment, when the operator moves the cursor of the pointing device onto the guideline on the editing screen, the controller highlights the intersecting point at which the guideline intersects with the other guideline. When the operator selects the intersecting point, the guidelines intersecting at the intersecting point are selected. This allows the operator to easily draw the shapes drawn on the raster image by tracing and drawing the selected guidelines.

In the drawing assistance device 1 according to the present embodiment, when the operator selects the area of the front view on the editing screen, and designates the correspondence between the guidelines drawn on the two areas other than the front view, the dimension values on the two areas other than the front view is caused to conform to each other. This allows the operator to draw the accurate side view by use of the dimension values in the top view even if the dimension values are not indicated in the side view.

In the drawing assistance device 1 according to the present embodiment, when the detected lines are not a horizontal or vertical line, the lines are rotated to be corrected so as to be oriented horizontally or vertically. This enables the horizontal or vertical correction of the lines if the lines on the input raster image are leaned.

The drawing assistance device 1 according to the present embodiment erases the title information drawn on the image data. Erasing the unnecessary information drawn on the image data can reduce the processing load to enhance the processing speed accordingly.

The drawing assistance device 1 according to the present embodiment changes the dimension value assigned to the dimension line so as to change the length of the dimension line. This enables the operator to easily draw up the parts having similar shapes but different sizes.

The drawing assistance device 1 according to the present embodiment detects the symbol drawn on the image data, detects the dimension value corresponding to the position of the symbol from the dimensional information, assigns the detected dimension value to the symbol, and sets the size of the symbol to the dimension value assigned to the symbol. As a result, the symbol having an accurate dimension value can be easily drawn.

The embodiment described above is an example of the present invention. It should be understood that the present invention is not intended to be limited to the embodiment described above, and various modifications can be made depending on the design, in addition to the present embodiment, within the range not departing from the technical idea of the present invention.

### Reference Signs List

1 DRAWING ASSISTANCE DEVICE
11 DIMENSIONAL INFORMATION DETECTION UNIT
13 ARROW DETECTION UNIT
15 SYMBOL DETECTION UNIT
17 LINE DETECTION UNIT
19 DIMENSION LINE GENERATION UNIT
21 GUIDELINE GENERATION UNIT
23 EDITOR
81 TITLE INFORMATION
83 OUTER CIRCUMFERENCE
100 CONTROLLER
200 INPUT UNIT
300 DISPLAY DEVICE
DL1, DL20 to DL23, DL36 DIMENSION LINE
GL, GL1 to GL4, GL20, GL25, GL30, GL32 GUIDELINE
L1, L3, L11 to L14 LINE
V1 FRONT VIEW
V2 TOP VIEW
V3 SIDE VIEW

## Claims

1. A drawing assistance device (1) comprising a controller (100) configured to assist an operator with a drawing operation of converting image data of a design diagram into digital data, the controller (100) being configured to:
acquire the image data of the design diagram to detect dimensional information drawn on the image data;
detect an arrow drawn on the image data;
detect a line drawn on the image data;
combine the arrow and the line based on a position of the arrow and a position of the line to generate a dimension line;
detect a dimension value corresponding to a position of the dimension line from the dimensional information so as to assign the detected dimension value to the dimension line,
**characterized in that**
the controller is further configured to:
generate guidelines perpendicular to the dimension line and passing through positions of ends of the dimension line;
superpose the guidelines on the image data to display the guidelines on an editing screen; and
output the digital data of the design diagram drawn by the operator on the editing screen on which the guidelines are displayed.

2. The drawing assistance device (1) according to claim 1, wherein a length of the dimension line is set to the dimension value assigned to the dimension line.

3. The drawing assistance device (1) according to claim 1 or 2, wherein, when the operator moves a cursor of a pointing device onto one of the guidelines on the editing screen, the controller (100) highlights an intersecting point at which the guideline and another guideline intersect with each other, and selects the guidelines intersecting at the intersecting point when the operator selects the intersecting point.

4. The drawing assistance device (1) according to any one of claims 1 to 3, wherein, when the operator selects an area of a front view of the image data on the editing screen and designates a correspondence between the guidelines drawn on two areas other than the front view, the controller (100) causes dimension values drawn on the two area other than the front view to conform to each other.

5. The drawing assistance device (1) according to any one of claims 1 to 4, wherein the detected line is rotated to be corrected so as to be oriented horizontally or vertically when the line is not a horizontal or vertical line.

6. The drawing assistance device (1) according to any one of claims 1 to 5, wherein the controller (100) erases title information drawn on the image data.

7. The drawing assistance device (1) according to any one of claims 1 to 6, wherein the dimension value assigned to the dimension line is changed so as to change a length of the dimension line.

8. The drawing assistance device (1) according to any one of claims 1 to 7, wherein the controller (100) detects a symbol drawn on the image data, detects a dimension value corresponding to a position of the symbol from the dimensional information, assigns the detected dimension value to the symbol, and sets a size of the symbol to the dimension value assigned to the symbol.

9. A computer-implemented drawing assistance method executed by a controller (100) configured to assist an operator with a drawing operation of converting image data of a design diagram into digital data, the drawing assistance method comprising:
acquiring the image data of the design diagram to detect dimensional information drawn on the image data;
detecting an arrow drawn on the image data;
detecting a line drawn on the image data;
combining the arrow and the line based on a position of the arrow and a position of the line to generate a dimension line;
detecting a dimension value corresponding to a position of the dimension line from the dimensional information so as to assign the detected dimension value to the dimension line,
**characterized in that**
the drawing assistance method further comprises
generating guidelines perpendicular to the dimension line and passing through positions of ends of the dimension line;
superposing the guidelines on the image data to display the guidelines on an editing screen; and
outputting the digital data of the design diagram drawn by the operator on the editing screen on which the guidelines are displayed.

## Patentansprüche

1. Eine Zeichenassistenzvorrichtung (1) aufweisend eine Steuereinheit (100), die so konfiguriert ist, dass sie einen Bediener bei einer Zeichenoperation unterstützt, bei der Bilddaten eines Konstruktionsdiagramms in digitale Daten umgewandelt werden, wobei die Steuereinheit (100) so konfiguriert ist, dass sie:
die Bilddaten des Konstruktionsdiagramms erfasst, um auf den Bilddaten gezeichnete Maßangaben zu erkennen;
auf den Bilddaten gezeichnete Pfeile erkennt;
auf den Bilddaten gezeichnete Linien erkennt;
Kombinieren des Pfeils und der Linie auf Basis einer Position des Pfeils und einer Position der Linie, um eine Maßlinie zu erzeugen;
Erfassen eines Maßwerts, der einer Position der Maßlinie aus den Maßangaben entspricht, um den erfassten Maßwert der Maßlinie zuzuweisen,
**dadurch gekennzeichnet, dass**
die Steuereinheit weiter konfiguriert ist, dass sie:
Hilfslinien erzeugt, die senkrecht zur Maßlinie stehen und durch Positionen der Enden der Maßlinie verlaufen;
die Hilfslinien über die Bilddaten zu legen, um die Hilfslinien auf einem Bearbeitungsbildschirm anzuzeigen; und
die digitalen Daten des vom Bediener auf dem Bearbeitungsbildschirm gezeichneten Konstruktionsdiagramms, auf dem die Hilfslinien angezeigt werden, ausgibt.

2. Die Zeichenassistenzvorrichtung (1) nach Anspruch 1, wobei eine Länge der Maßlinie auf den der Maßlinie zugewiesenen Maßwert eingestellt wird.

3. Die Zeichenassistenzvorrichtung (1) gemäß Anspruch 1 oder 2, wobei, wenn der Bediener einen Cursor eines Zeigegeräts auf eine der Hilfslinien auf dem Bearbeitungsbildschirm bewegt, die Steuereinheit (100) einen Schnittpunkt hervorhebt, an dem sich die Hilfslinie und eine andere Hilfslinie schneiden, und die sich am Schnittpunkt schneidenden Hilfslinien auswählt, wenn der Bediener den Schnittpunkt auswählt.

4. Die Zeichenassistenzvorrichtung (1) gemäß einem der Ansprüche 1 bis 3, wobei, wenn der Bediener einen Bereich einer Vorderansicht der Bilddaten auf dem Bearbeitungsbildschirm auswählt und eine Entsprechung zwischen den auf zwei anderen Bereichen als der Vorderansicht gezeichneten Hilfslinien festlegt, die Steuereinheit (100) bewirkt, dass die auf den beiden anderen Bereichen als der Vorderansicht gezeichneten Maßwerte miteinander übereinstimmen.

5. Die Zeichenassistenzvorrichtung (1) nach einem der Ansprüche 1 bis 4, wobei die erkannte Linie rotierend wird, um sie so zu korrigieren, dass sie horizontal oder vertikal ausgerichtet ist, wenn die Linie keine horizontale oder vertikale Linie ist.

6. Die Zeichenassistenzvorrichtung (1) nach einem der Ansprüche 1 bis 5, wobei die Steuereinheit (100) Titelinformationen löscht, die auf die Bilddaten gezeichnet wurden.

7. Die Zeichenassistenzvorrichtung (1) nach einem der Ansprüche 1 bis 6, wobei der der Maßlinie zugewiesene Maßwert so geändert wird, dass sich die Länge der Maßlinie ändert.

8. Die Zeichenassistenzvorrichtung (1) nach einem der Ansprüche 1 bis 7, wobei die Steuereinheit (100) ein auf die Bilddaten gezeichnetes Symbol erkennt, einen der Position des Symbols entsprechenden Maßwert aus den Maßangaben erkennt, den erkannten Maßwert dem Symbol zuweist und eine Größe des Symbols auf den dem Symbol zugewiesenen Maßwert einstellt.

9. Ein computerimplementiertes Zeichenassistenzverfahren, das von einer Steuereinheit (100) ausgeführt wird, die so konfiguriert ist, dass sie einen Bediener bei einer Zeichenoperation unterstützt, bei der Bilddaten eines Konstruktionsdiagramms in digitale Daten umgewandelt werden, das Verfahren weist auf:
Erfassen der Bilddaten des Konstruktionsdiagramms, um auf den Bilddaten gezeichnete Maßinformationen zu erkennen;
Erkennen eines auf den Bilddaten gezeichneten Pfeils;
Erkennen einer auf den Bilddaten gezeichneten Linie;
Kombinieren des Pfeils und der Linie auf der Grundlage einer Position des Pfeils und einer Position der Linie, um eine Maßlinie zu erzeugen;
Erfassen eines Maßwerts, der einer Position der Maßlinie aus den Maßangaben entspricht, um den erfassten Maßwert der Maßlinie zuzuweisen,
**dadurch gekennzeichnet, dass**
das Zeichenassistenzverfahren weiter aufweist
Erzeugen von Hilfslinien, die senkrecht zur Maßlinie stehen und durch Positionen von Enden der Maßlinie verlaufen;
Überlagern der Hilfslinien mit den Bilddaten, um die Hilfslinien auf einem Bearbeitungsbildschirm anzuzeigen; und
Ausgeben der digitalen Daten des vom Bediener auf dem Bearbeitungsbildschirm gezeichneten Konstruktionsdiagramms, auf dem die Hilfslinien angezeigt werden.

## Revendications

1. Dispositif d'aide au dessin (1) comprenant un dispositif de commande (100) configuré pour aider un opérateur dans une opération de dessin consistant à convertir des données d'image d'un diagramme de conception en données numériques, le dispositif de commande (100) étant configuré pour:
acquérir les données d'image du diagramme de conception afin de détecter les informations dimensionnelles dessinées sur les données d'image;
détecter une flèche dessinée sur les données d'image;
détecter une ligne dessinée sur les données d'image;
combiner la flèche et la ligne en fonction d'une position de la flèche et d'une position de la ligne afin de générer une ligne de cote;
détecter une valeur dimensionnelle correspondant à une position de la ligne dimensionnelle à partir des informations dimensionnelles afin d'attribuer la valeur dimensionnelle détectée à la ligne dimensionnelle,
**caractérisé en ce que**
le dispositif de commande est en outre configuré pour:
générer des lignes directrices perpendiculaires à la ligne de cote et passant par les positions des extrémités de la ligne de cote;
superposer les lignes directrices sur les données d'image afin d'afficher les lignes directrices sur un écran d'édition; et
produire les données numériques du diagramme de conception dessiné par l'opérateur sur l'écran d'édition sur lequel les lignes directrices sont affichées.

2. Dispositif d'aide au dessin (1) selon la revendication 1, dans lequel la longueur de la ligne de cote est définie par la valeur de cote attribuée à la ligne de cote.

3. Dispositif d'aide au dessin (1) selon les revendications 1 ou 2, dans lequel, lorsque l'opérateur déplace un curseur d'un dispositif de pointage sur l'une des lignes directrices sur l'écran d'édition, le dispositif de commande (100) met en évidence un point d'intersection où la ligne directrice et une autre ligne directrice se croisent, et sélectionne les lignes directrices qui se croisent au point d'intersection lorsque l'opérateur sélectionne le point d'intersection.

4. Dispositif d'aide au dessin (1) selon l'une quelconque des revendications 1 à 3, dans lequel, lorsque l'opérateur sélectionne une zone d'une vue de face des données d'image sur l'écran d'édition et désigne une correspondance entre les lignes directrices tracées sur deux zones autres que la vue de face, le dispositif de commande (100) fait en sorte que les valeurs dimensionnelles tracées sur les deux zones autres que la vue de face se conforment les unes aux autres.

5. Dispositif d'aide au dessin (1) selon l'une quelconque des revendications 1 à 4, dans lequel la ligne détectée pivote pour être corrigée de manière à être orientée horizontalement ou verticalement lorsque la ligne n'est pas une ligne horizontale ou verticale.

6. Dispositif d'aide au dessin (1) selon l'une quelconque des revendications 1 à 5, dans lequel le dispositif de commande (100) efface les informations de titre dessinées sur les données d'image.

7. Dispositif d'aide au dessin (1) selon l'une quelconque des revendications 1 à 6, dans lequel la valeur dimensionnelle attribuée à la ligne de cote est modifiée de manière à modifier la longueur de la ligne de cote.

8. Dispositif d'aide au dessin (1) selon l'une quelconque des revendications 1 à 7, dans lequel le dispositif de commande (100) détecte un symbole dessiné sur les données d'image, détecte une valeur dimensionnelle correspondant à une position du symbole à partir des informations dimensionnelles, attribue la valeur dimensionnelle détectée au symbole et définit une taille du symbole à la valeur dimensionnelle attribuée au symbole.

9. Procédé d'aide au dessin mis en œuvre par ordinateur, exécuté par un dispositif de commande (100) configuré pour aider un opérateur dans une opération de dessin consistant à convertir des données d'image d'un schéma de conception en données numériques, le procédé d'aide au dessin comprenant les opérations suivantes:
acquérir des données d'image du diagramme de conception afin de détecter les informations dimensionnelles dessinées sur les données d'image;
détecter une flèche dessinée sur les données d'image;
détecter une ligne dessinée sur les données d'image;
combiner la flèche et la ligne en fonction d'une position de la flèche et d'une position de la ligne pour générer une ligne de cote;
détecter une valeur dimensionnelle correspondant à une position de la ligne dimensionnelle à partir des informations dimensionnelles afin d'attribuer la valeur dimensionnelle détectée à la ligne dimensionnelle,
**caractérisé en ce que**
le procédé d'aide au dessin comprend en outre les opérations suivantes:
générer des lignes directrices perpendiculaires à la ligne de cote et passant par les positions des extrémités de la ligne de cote;
superposer les lignes directrices sur les données d'image afin d'afficher les lignes directrices sur un écran d'édition; et
produire les données numériques du diagramme de conception dessiné par l'opérateur sur l'écran d'édition sur lequel les lignes directrices sont affichées.
